# FASCICULE DE BREVET EUROPEEN

(11) **EP 4 372 986 B1**
(45) Date de publication et mention de la délivrance du brevet: **11.06.2025**
(21) Numéro de dépôt: 23210029.7
(22) Date de dépôt: 15.11.2023
(51) Int. Cl.: H03G 5/16, H03G 3/32, H04R 3/04

(54) **PROCÉDÉ D ÉGALISATION D'UN SIGNAL AUDIOFRÉQUENCES DIFFUSÉ DANS UN ENVIRONNEMENT DE DIFFUSION, PRODUIT PROGRAMME D ORDINATEUR ET DISPOSITIF CORRESPONDANT**
VERFAHREN ZUM ENTZERREN EINES IN EINER RUNDFUNKUMGEBUNG GESENDETEN AUDIOSIGNALS, COMPUTERPROGRAMMPRODUKT UND VORRICHTUNG DAFÜR
METHOD FOR EQUALIZING A BROADCAST AUDIO FREQUENCY SIGNAL IN A BROADCAST ENVIRONMENT, COMPUTER PROGRAM PRODUCT AND CORRESPONDING DEVICE

(30) Priorité: 16.11.2022 FR 2211921
(43) Date de publication de la demande: 22.05.2024
(73) Titulaire: Arkamys, 92300 Levallois-Perret (FR)
(72) Inventeur: JACQUET, Damien, 44200 Nantes (FR); ESNAULT, Thomas, 75018 Paris (FR); FADILI, Moulay, 95000 Cergy (FR)
(74) Mandataire: Ipside

(56) Documents cités:
- US-A1- 2005 207 583

## Description

### Domaine de l'invention

Le domaine de l'invention est celui du traitement de signaux audiofréquences.

L'invention se rapporte plus particulièrement à une méthode d'égalisation d'un tel signal dans un environnement pouvant être bruyant, notamment lorsque le bruit en question est susceptible de varier dans le temps.

L'invention a de nombreuses applications, notamment, mais non exclusivement, pour la diffusion d'un signal audiofréquences dans tout type d'environnement de diffusion, e.g. un stade de sport, une salle de spectacle, l'habitacle d'un véhicule du type voiture ou équivalent, etc.

### Art antérieur et ses inconvénients

On s'attache plus particulièrement dans la suite de ce document à décrire une problématique existante dans le domaine de la diffusion d'un signal audiofréquence dans un habitacle de véhicule du type voiture, à laquelle ont été confrontés les inventeurs de la présente demande de brevet. L'invention ne se limite bien sûr pas à ce domaine particulier d'application, mais présente un intérêt pour la diffusion de signaux audiofréquences dans tout type d'environnement de diffusion (e.g. un stade de sport, une salle de spectacle, etc.), notamment lorsque l'environnement est bruyant et que le bruit en question est susceptible de varier dans le temps. L'effet de masquage d'un premier signal audiofréquences par un deuxième signal audiofréquences est le processus par lequel le seuil d'audition pour le premier signal se trouve relevé par la présence du deuxième signal. En d'autres termes, le masquage spectral se produit dans une bande de fréquence donnée lorsque la présence du deuxième signal ne permet pas la détection du premier signal d'amplitude inférieure dans la même bande de fréquence.

Dans une voiture, cet effet est généralement créé par le bruit aérodynamique lié au roulement de la voiture, ainsi que par le bruit du moteur. En présence de bruit, la perception de l'équilibre spectral de la musique diffusé dans l'habitacle de la voiture peut alors être altérée car certaines fréquences seront masquées.

L'équilibre tonal perçu dépend de la différence entre le niveau sonore de diffusion et le seuil de masquage. Comme les signaux musicaux présentent une dynamique donnée (différence entre les amplitudes les plus élevées et les plus basses), pour une valeur de niveau moyen donnée en dB SPL (pour « Sound Pressure Level » en anglais) proche du seuil, certaines composantes du signal seront perçues et d'autres seront masquées.

Afin d'éviter le phénomène de masquage et de préserver l'équilibre tonal perçu, il est nécessaire d'augmenter certaines fréquences du signal audiofréquences diffusé au-delà du seuil de masquage. Dans l'état de l'art, deux types de techniques sont classiquement mises en œuvre afin d'adresser cette problématique d'effet de masquage :
- Une technique dite SDVC (pour « Speed Dependent Volume Control » en anglais) qui consiste à ajouter un gain calculé à partir d'une table de vitesse pour augmenter le volume sonore du signal audiofréquences (i.e. l'ensemble du signal audiofréquences) au-dessus du seuil de masquage ; et
- Une technique dite SDEC (pour « Speed Dependent Equalization control » en anglais) qui consiste en l'application d'un filtre en plateaux basses fréquences (ou « low shelf filter » dans la littérature anglo-saxonne) dont les paramètres dépendent de la vitesse et de l'atténuation globale du système.

Cependant, le bruit de fond dans un véhicule du type voiture à plusieurs sources parmi lesquelles on peut citer à titre d'exemples :
- La configuration de la voiture elle-même : e.g. isolation acoustique, forme aérodynamique, type de pneus, moteur, etc. ;
- Certaines fonctionnalités du véhicule qui peuvent modifier le bruit de fond : e.g. système HVAC (pour « Healing, Ventilation and Air-Conditioning » en anglais), activation / désactivation du moteur thermique des voitures hybrides, etc. ;
- La vitesse de la voiture : e.g. les bruits de roulement et les bruits aérodynamiques augmentent avec la vitesse ;
- La nature de la surface de la route : e.g. les routes ou chaussées goudronnées à gros grains sont plus bruyantes que les routes goudronnées lisses ; et
- L'environnement : e.g. les routes de campagne ouvertes sont moins bruyantes que les tunnels. La pluie et le vent augmentent également le bruit de fond dans le véhicule.

Le bruit de fond peut généralement être décrit comme un bruit à large bande avec une décroissance de 6 dB par octave dans les hautes fréquences. Cependant, en fonction des sources de bruit listées ci-dessus, cette définition peut ne pas être suffisante pour décrire les phénomènes de masquage rencontrés en pratique. Par exemple, en présence de pluie les hautes fréquences peuvent également être masquées. De même, en fonction de la nature du véhicule et de sa vitesse, les bandes de fréquences effectivement masquées peuvent changer dans le temps.

Face à de tels effets de masquage variables, on peut observer que :
- La fonction SDVC augmente le niveau de l'ensemble du signal lorsque la vitesse augmente. Cependant, la perception du signal audiofréquences diffusé n'est pas linéaire autour du seuil de masquage (Par exemple, les hautes fréquences peuvent être mieux perçues que les basses fréquences). Ainsi, au fur et à mesure que la vitesse augmente, la fonction SDVC augmente le niveau de l'ensemble du signal alors que ce n'est pas forcément nécessaire pour toutes les fréquences.
- La fonction SDEC introduit un certain traitement spectral pour éviter l'effet précédent. En amplifiant le signal avec un filtre en plateaux basses fréquences, la fonction SDEC garantit que pour un profil de bruit classique (i.e. présentant une décroissance de 6 dB par octave dans les hautes fréquences), les basses fréquences sont augmentées au-dessus du seuil de masquage et l'équilibre spectral perçu est préservé. Mais l'hypothèse est ici que le profil de bruit de fond ne dépend que de la vitesse du véhicule. Mais comme décrit ci-dessus, un tel profil peut changer radicalement et de manière imprévisible, e.g. avec la surface de la route ou l'environnement.

Il existe ainsi un besoin pour une technique d'égalisation d'un signal audiofréquences diffusé dans un environnement présentant un bruit de fond dont les caractéristiques (en intensité et/ou forme spectrale) varient dans le temps, comme ce peut être le cas par exemple dans un véhicule du type voiture. US 2005/207583 A1 divulgue un procédé et un dispositif de contrôle d'égaliseur dynamique (Dynamic Equalizer Control, DEC) pour compenser le bruit ambiant dans un environnement d'écoute, par exemple à l'intérieur d'un véhicule, comprenant la détection du signal sonore total dans l'environnement (par exemple à l'aide d'un microphone) pour mesurer à la fois la musique et le bruit, l'extraction du bruit ambiant du signal sonore total à l'aide d'un filtrage adaptatif, la génération d'un signal de contrôle pour l'égaliseur à partir du signal de bruit ambiant approximé à l'aide d'une analyse par codage prédictif linéaire (CPL), et l'égalisation du signal sonore pour compenser le bruit ambiant. L'égaliseur est un filtre prédicteur. La méthode est ensuite améliorée pour tenir compte de l'audition humaine en utilisant un filtre psycho-acoustique pour filtrer le signal de bruit approximé avant l'analyse CPL. Une autre mise en œuvre utilise une combinaison d'un formateur de faisceau (beamformer) et d'un filtre adaptatif pour éliminer une composante vocale du signal de bruit approximé.

### Exposé de l'invention

Dans un mode de réalisation de l'invention, il est proposé un procédé d'égalisation d'un signal audiofréquences diffusé dans un environnement de diffusion par un système de diffusion comprenant au moins un haut-parleur. Un tel procédé comprend :
- une estimation d'un profil fréquentiel d'un signal de bruit représentatif d'un bruit de fond présent dans l'environnement de diffusion, à partir, d'une part, d'un signal, dit signal capturé, issu d'une capture par au moins un microphone implémenté dans l'environnement de diffusion et, d'autre part, dudit signal audiofréquences ;
- une détermination d'un profil fréquentiel souhaité pour le signal audiofréquences diffusé ;
- une détermination d'un masque acoustique fréquentiel représentatif, pour chaque composante fréquentielle, d'une différence entre le profil fréquentiel du signal de bruit et le profil fréquentiel souhaité ; et
- une égalisation du signal audiofréquences via une pondération d'un spectre du signal audiofréquences par application d'un masque de pondération fréquentiel fonction du masque acoustique fréquentiel, délivrant le signal audiofréquences égalisé.

Ainsi, l'invention propose une solution nouvelle et inventive pour égaliser un signal audiofréquences diffusé dans un environnement de diffusion.

Plus particulièrement, la prise en compte du bruit effectif présent dans l'environnement de diffusion (e.g. un véhicule, un stade de sport, une pièce dans un bâtiment, une salle de spectacle, etc.) via le ou les microphones permet une adaptation de l'égalisation à tous types de bruits pouvant être présents dans un tel environnement de diffusion (e.g. pour un véhicule : le bruit aérodynamique de roulement, le bruit moteur, du contact des pneus sur la route dans le cas d'une voiture, etc.) ainsi que leur évolution dans le temps.

Par ailleurs l'égalisation via une pondération du spectre du signal audiofréquences permet une égalisation plus fine que via l'utilisation d'un filtre classique du type filtre en plateau.

Dans des modes de réalisation, le masque acoustique fréquentiel est représentatif, pour chaque composante fréquentielle, de ladite différence lorsque ladite différence est supérieure à un seuil prédéterminé.

En d'autres termes, le signal audiofréquences, pour une composante fréquentielle donnée, est considéré comme masqué si l'énergie du bruit de fond dépasse la valeur cible pour le signal audiofréquences d'une quantité au moins égale au seuil prédéterminé. Ainsi, le seuil peut être vu comme un décalage appliqué sur le masque acoustique. Un tel seuil permet de prendre en compte et de préserver la dynamique du signal audiofréquences.

Dans des modes de réalisation, le masque de pondération fréquentiel est obtenu par mise en œuvre d'une pondération de différentes composantes fréquentielles du masque acoustique fréquentiel par application de valeurs de pondérations prédéterminées.

Ainsi, la dureté ou la sibilance en haute fréquences peut être contrôlée. Ce contrôle par pondération permet également de prendre en compte perceptivement le manque de précision de l'extraction du bruit en le réglant à l'oreille en conditions opérationnelles pour un type d'environnement de diffusion donné.

Dans des modes de réalisation, les valeurs du masque de pondération fréquentiel sont limitées à une valeur maximale et à une valeur minimale.

Ainsi, la valeur maximale définit une pondération maximale du spectre du signal audiofréquences permettant d'éviter toute divergence dans la détermination de la correction et limiter le gain global. Un gain excessif pourrait en effet trop modifier la perception audio (via l'effet « loudness » selon le terme anglosaxon consacré) cible du signal audiofréquences.

De même, la valeur minimale, e.g. correspondant à une pondération de 0 dB, permet de ne pas réduire (ou de limiter la réduction) de la dynamique du signal audiofréquences.

Dans des modes de réalisation, la détermination d'un profil fréquentiel souhaité met en œuvre un calcul d'une répartition fréquentielle souhaitée d'une énergie du signal audiofréquences en fonction d'au moins un paramètre appartenant au groupe comprenant :
- un volume sonore de diffusion du signal audiofréquences. Par exemple, dans le cas où l'environnement de diffusion est l'intérieur d'un véhicule, un tel volume sonore de diffusion du signal audiofréquences peut être variable ou non en fonction d'une vitesse de déplacement du véhicule;
- une intensité, variable en fréquence, dépendent du volume sonore ;
- une égalisation fréquentielle prédéfinie ;
- un ou plusieurs paramètres de configuration dudit système de diffusion ; et
- lorsque ledit système de diffusion comprend une pluralité de haut-parleurs, un ou plusieurs paramètres de répartition dudit signal audiofréquences entre lesdits haut-parleurs.

Ainsi, le profil fréquentiel souhaité pour le signal audiofréquences dans l'environnement de diffusion est obtenu, par exemple à un point d'écoute donné.

Dans des modes de réalisation, ladite estimation d'un profil fréquentiel du signal de bruit met en œuvre une correction d'une fonction de transfert dudit au moins un microphone.

Ainsi, les erreurs de capture du signal de bruit induites par le ou les microphones sont compensées.

Dans des modes de réalisation, le procédé comprend :
- une estimation du signal de bruit ; et
- une détection d'au moins un signal vocal présent dans le signal de bruit délivrant une information de détection.

Les étapes d'estimation, de détermination et d'égalisation sont mises en œuvre périodiquement pour différents échantillons du signal capturé et du signal audiofréquences. L'égalisation fréquentielle implémente, pour une mise en œuvre donnée :
- lorsque ladite information de détection est représentative d'une absence de détection d'au moins un signal vocal dans le signal de bruit : le masque de pondération fréquentiel correspondant au masque acoustique fréquentiel déterminé lors de la mise en œuvre donnée desdites étapes ; ou
- lorsque ladite information de détection est représentative d'une détection d'au moins un signal vocal dans le signal de bruit : le masque de pondération fréquentiel correspondant au masque acoustique fréquentiel déterminé lors d'une précédente mise en œuvre desdites étapes.

Ainsi, les paramètres de correction sont gelés lorsque des signaux de voix non présents initialement dans le signal audiofréquences sont détectés dans le signal capturé issu du ou des microphones (e.g. pour un véhicule : la voix des passagers du véhicule). De la sorte, des divergences ou des artéfacts dans l'égalisation sont évités.

Dans des modes de réalisation, le procédé comprend :
- une estimation du signal de bruit ; et
- une détection d'au moins un signal vocal présent dans le signal de bruit délivrant une information de détection.

Les étapes d'estimation, de détermination et d'égalisation sont mises en œuvre périodiquement pour différents échantillons du signal capturé et du signal audiofréquences. La détection d'au moins un signal vocal met en œuvre une estimation d'une probabilité de présence d'au moins un signal vocal dans le signal de bruit. L'égalisation fréquentielle implémente, pour une mise en œuvre donnée, le masque de pondération fréquentiel correspondant à une combinaison linéaire pondérée entre, d'une part, le masque acoustique fréquentiel déterminé lors d'une précédente mise en œuvre desdites étapes et, d'autre part, le masque acoustique fréquentiel déterminé lors de la mise en œuvre donnée desdites étapes. La pondération est fonction de la probabilité de présence de sorte que la combinaison linéaire se réduit :
- au masque acoustique fréquentiel déterminé lors d'une précédente mise en œuvre desdites étapes lorsque la probabilité de présence d'au moins un signal vocal dans ledit signal de bruit est égale à 1; et
- au masque acoustique fréquentiel déterminé lors de la mise en œuvre donnée desdites étapes lorsque la probabilité de présence d'au moins un signal vocal dans ledit signal de bruit est nulle. Dans des modes de réalisation, la combinaison linéaire pondérée s'exprime comme Pvp(f)=PO(f)+ α(p).(Pm(f)-P0(f)), avec :
- PO(f) le masque acoustique fréquentiel déterminé lors d'une précédente mise en œuvre des étapes d'estimation, de détermination et d'égalisation ;
- Pm(f) le masque acoustique fréquentiel déterminé lors de la mise en œuvre donnée des étapes précitées ; et
- α(p)=1-p ladite pondération fonction de ladite probabilité de présence, avec p la probabilité de présence.

Dans des modes de réalisation, l'égalisation fréquentielle implémente un lissage temporel du masque de pondération fréquentiel suivant la loi Pvp_m(n,f)=β(n).(Pvp(f)-Pvp_m(n-1,f)), avec :
- Pvp_m(n,f) le masque de pondération fréquentiel lissé dans le temps pour une fréquence f de la bande du signal à égaliser lors de la n-ième mise en œuvre des étapes d'estimation, de détermination et d'égalisation ;
- Pvp(f) le masque de pondération fréquentiel calculé lors de la n-ième mise en œuvre desdites étapes ;
- Pvp_m(n-1,f) le masque de pondération fréquentiel lissé pour une fréquence f de la bande du signal à égaliser lors de la (n-1)-ième mise en œuvre desdites étapes ; et
- β(n) un facteur de pondération compris entre 0 et 1.

Dans des modes de réalisation, l'estimation du signal de bruit met en œuvre une méthode d'estimation spectrale de bruit de fond, à partir, d'une part, du signal capturé et, d'autre part, du signal audiofréquences. L'estimation du profil fréquentiel du signal de bruit comprend :
- une application d'un banc de filtres au signal de bruit délivrant une pluralité de signaux de bruit filtrés,
- une détection d'enveloppe de chacun des signaux de bruit filtrés délivrant une pluralité correspondante d'enveloppes de signaux de bruit filtrés,
- un filtrage passe-bas de chacune des enveloppes de signaux de bruit filtrés délivrant une pluralité correspondante de composantes du profil fréquentiel du signal de bruit.

Dans des modes de réalisation, l'estimation du profil fréquentiel du signal de bruit comprend :
- une application d'un banc de filtres au signal capturé délivrant une pluralité de signaux capturés filtrés,
- pour chacun des signaux capturés filtrés : une mise en œuvre d'une méthode d'estimation spectrale de bruit de fond, à partir, d'une part, du signal capturé filtré et, d'autre part, du signal audiofréquences délivrant une pluralité correspondante de signaux de bruit filtrés,
- une détection d'enveloppe de chacun des signaux de bruit filtrés délivrant une pluralité correspondante d'enveloppes de signaux de bruit filtrés,
- un filtrage passe-bas de chacune des enveloppes de signaux de bruit filtrés délivrant une pluralité correspondante de composantes du profil fréquentiel du signal de bruit.

L'estimation du signal de bruit met en œuvre une sommation de chacun des signaux de bruit filtrés.

Par exemple, la méthode d'estimation spectrale de bruit de fond en question est une méthode d'estimation spectrale de bruit de fond telle que mise en œuvre dans les méthodes de réduction de bruit par annulation d'échos, dites ECNR, telles que rencontrées par exemple dans le domaine de la téléphonie mobile.

Dans des modes de réalisation, le procédé comprend un moyennage d'une pluralité de signaux capturés chacun par un microphone différent implémenté dans l'environnement de diffusion. Le moyennage délivre le signal capturé.

L'invention concerne également un programme d'ordinateur comprenant des instructions de code de programme pour la mise en œuvre d'un procédé tel que décrit précédemment, selon l'un quelconque de ses différents modes de réalisation, lorsqu'il est exécuté sur un ordinateur. L'invention concerne également un dispositif d'égalisation d'un signal audiofréquences diffusé dans un environnement de diffusion par un système de diffusion comprenant au moins un haut-parleur. Un tel dispositif d'égalisation comprend une machine de calcul reprogrammable ou une machine de calcul dédiée configurée pour mettre en œuvre les étapes du procédé d'égalisation selon l'invention (selon l'un quelconque des différents modes de réalisation précités). Ainsi, les caractéristiques et avantages de ce dispositif sont les mêmes que ceux des étapes correspondantes du procédé d'égalisation décrit précédemment. Par conséquent, ils ne sont pas détaillés plus amplement.

### Liste des figures

D'autres buts, caractéristiques et avantages de l'invention apparaîtront plus clairement à la lecture de la description suivante, donnée à titre de simple exemple illustratif, et non limitatif, en relation avec les figures, parmi lesquelles :
[Fig.1] représente un système de diffusion d'un signal audiofréquences implémenté dans un véhicule selon un mode de réalisation de l'invention ;
[Fig.2a] illustre les étapes d'un procédé d'égalisation du signal audiofréquences diffusé par le système de diffusion de la [Fig.1] selon un mode de réalisation de l'invention ;
[Fig.2b] illustre les étapes de l'étape d'estimation du signal de bruit du procédé de la [Fig.2a] selon un mode de réalisation de l'invention ;
[Fig.2c] illustre les étapes du procédé d'égalisation du signal audiofréquences diffusé par le système de diffusion de la [Fig.1] selon un autre mode de réalisation de l'invention ;
[Fig.3a] illustre un profil fréquentiel du signal de bruit ainsi qu'un profil fréquentiel souhaité pour le signal audiofréquences diffusé tels qu'obtenus par application du procédé d'égalisation selon l'invention ;
[Fig.3b] illustre un masque acoustique fréquentiel représentatif, pour chaque composante fréquentielle, d'une différence entre le profil fréquentiel du signal de bruit et le profil fréquentiel souhaité tels qu'obtenus par application du procédé d'égalisation selon l'invention ;
[Fig.4] représente un exemple de structure de dispositif permettant la mise en œuvre de tout ou partie des étapes du procédé d'égalisation selon l'invention selon un mode de réalisation de l'invention.

### Description détaillée de modes de réalisation de l'invention

Le principe général de l'invention repose sur une estimation d'un profil fréquentiel d'un signal représentatif d'un bruit de fond présent dans un environnement de diffusion à partir, d'une part, d'un signal capturé par un (ou plusieurs) microphone implémenté dans l'environnement de diffusion et, d'autre part, d'un signal audiofréquences diffusé dans l'environnement de diffusion en question. Un masque acoustique fréquentiel représentatif, pour chaque composante fréquentielle, d'une différence entre le profil fréquentiel du signal de bruit et le profil fréquentiel souhaité pour le signal audiofréquences diffusé (e.g. lorsque les profils fréquentiels en question sont exprimés en unité logarithmique) est déterminé. Le signal audiofréquences est égalisé via une pondération de son spectre par application d'un masque de pondération fréquentiel fonction du masque acoustique fréquentiel.

Ainsi, la prise en compte du bruit effectif présent dans l'environnement de diffusion via le (ou les) microphone permet une adaptation de l'égalisation à tous les types de bruit pouvant être présents dans un tel environnement de diffusion e.g. pour un véhicule : le bruit aérodynamique de roulement, le bruit moteur, du contact des pneus sur la route dans le cas d'une voiture, etc.) ainsi que leur évolution dans le temps.

Par ailleurs, l'égalisation via une pondération du spectre du signal audiofréquences permet une égalisation plus fine que via l'utilisation d'un filtre classique du type filtre en plateau.

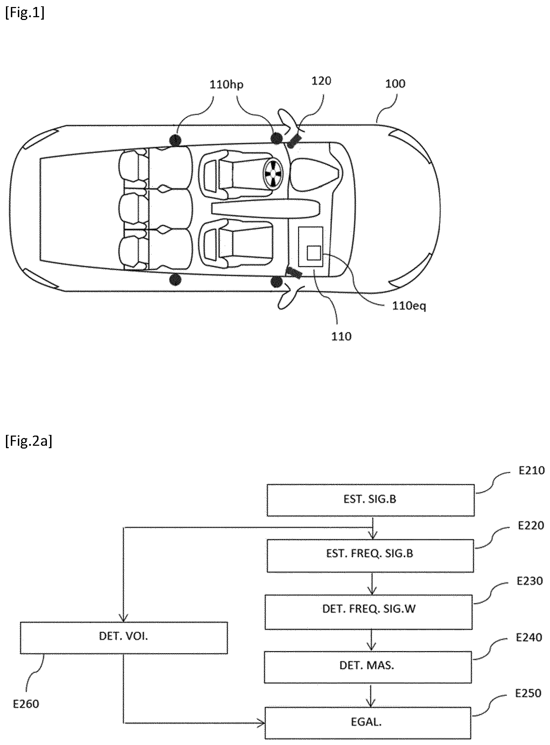

On présente désormais, en relation avec la **[****Fig.1****]** un système de diffusion 110 d'un signal audiofréquences implémenté dans un environnement de diffusion qui prend la forme d'un véhicule 100 selon un mode de réalisation de l'invention.

Le véhicule est ici représenté sous la forme d'une voiture, mais le procédé selon l'invention s'applique de la même manière à tous les types de véhicules.

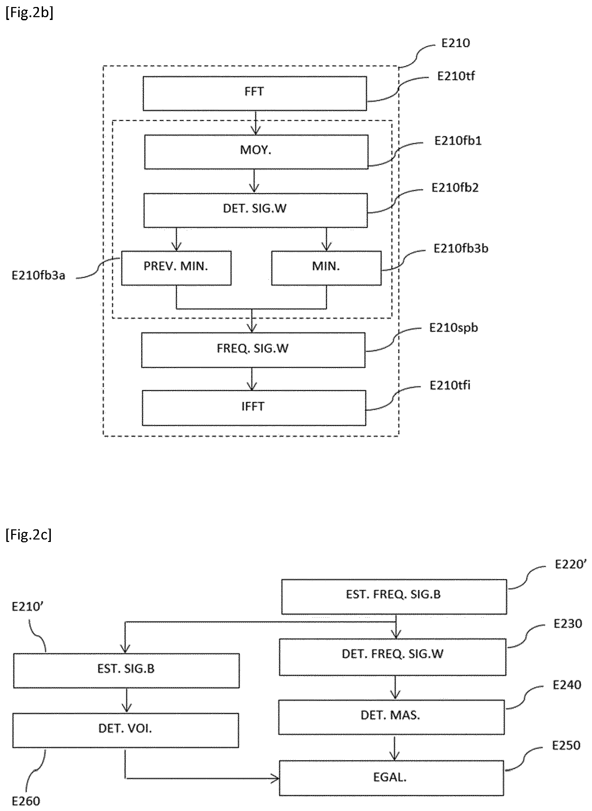

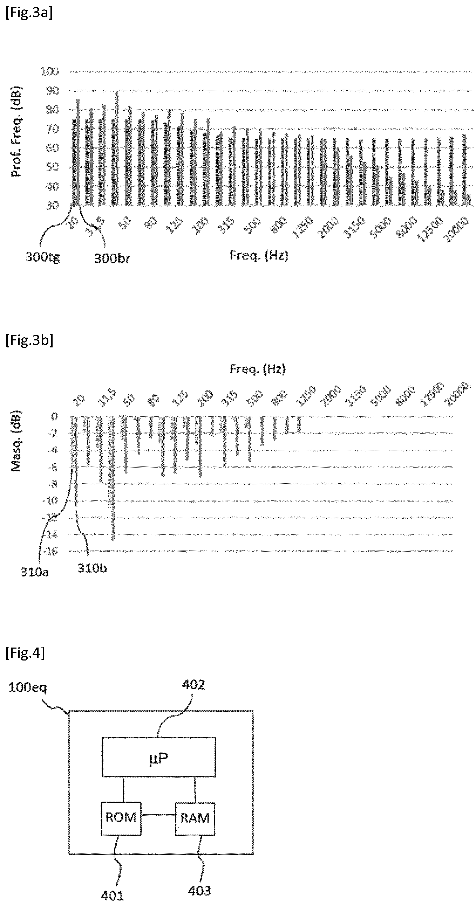

De retour à la [Fig.1], le système de diffusion 110 comprend plusieurs haut-parleurs 110hp ainsi qu'un dispositif d'égalisation 110eq selon l'invention. Un tel dispositif d'égalisation 110eq est configuré pour mettre en œuvre le procédé d'égalisation selon l'un quelconque des modes de réalisation décrit ci-dessous en relation avec la [Fig.2a], la [Fig.2b] ou la [Fig.2c]. Par ailleurs, des exemples de moyens mis en œuvre dans le dispositif d'égalisation 110eq sont détaillés ci-dessous en relation avec la [Fig.4].

Dans certains modes de réalisation, le dispositif d'égalisation 110eq n'est pas inclus dans le système de diffusion 110, mais connecté au système de diffusion 110 via une liaison filaire (e.g. liaison USB ou équivalente) ou radio (e.g. liaison Bluetooth, WiFi ou équivalente) afin d'échanger les données, e.g. le signal audiofréquences diffusé et le signal audiofréquences égalisé.

Dans certains modes de réalisation, le système de diffusion 110 comprend un seul haut-parleur 110hp.

De retour à la [Fig.1], le véhicule 100 est équipé de microphones 120 permettant de capturer un signal dans le véhicule 100. Plus particulièrement, le signal capturé comprend à la fois le bruit de fond du véhicule (e.g. le bruit aérodynamique de roulement), le signal audiofréquences tel que diffusé par les haut-parleurs 110hp et, le cas échéant, la voix du ou des occupants du véhicule.

Dans certains modes de réalisation, un seul microphone 120 est mis en œuvre pour capturer le signal dans le véhicule 100.

On présente désormais, en relation avec la **[****Fig.2a****]** les étapes d'un procédé d'égalisation du signal audiofréquences diffusé dans le véhicule 100 selon un mode de réalisation de l'invention. Des exemples d'implémentation des étapes du procédé d'égalisation en question est par ailleurs discuté en relation avec la **[****Fig.3a****]** et la **[****Fig.3b****].** Par ailleurs, la **[****Fig.2b****]** illustre les étapes de l'étape d'estimation du signal de bruit du procédé de la [Fig.2a] selon un mode de réalisation particulier.

De retour à la [Fig.2a], lors d'une **étape E210,** le dispositif d'égalisation 110eq estime un signal de bruit représentatif du bruit de fond présent dans le véhicule 100, à partir, d'une part, d'un signal, dit signal capturé, issu d'une capture par les microphones 120 et, d'autre part, du signal audiofréquences diffusé par le système de diffusion 110. Le signal audiofréquence est par exemple fourni au dispositif d'égalisation 110eq par le système de diffusion 110.

Par exemple, le signal capturé correspond à un moyennage de signaux capturés chacun par un des microphones 120. De la sorte, le bruit de fond tel que présent dans l'ensemble du véhicule est estimé de manière plus précise. Dans les modes de réalisation précités dans lesquels un seul microphone est mis en œuvre pour capturer le signal dans le véhicule 100, le signal capturé correspond au signal capturé par le microphone en question.

De retour à la [Fig.2a], le signal de bruit est par exemple estimé selon la mise en œuvre des étapes de la [Fig.2b].

Plus particulièrement, lors d'une **étape E210tf,** un spectrogramme du signal capturé est estimé, e.g. sur la base de transformées de Fourier du signal capturé. Un tel spectrogramme est par exemple estimé périodiquement. Par exemple, un spectrogramme mis à jour est délivré à chaque nouvel échantillon disponible du signal capturé.

Ainsi, pour chacune des composantes fréquentielles des spectrogrammes du signal capturé :
- lors d'une **étape E210fb1,** un moyennage temporel est appliqué, délivrant une composante fréquentielle moyennée ;
- lors d'une **étape E210fb2,** une détection du signal audiofréquence, e.g. tel que fourni au dispositif d'égalisation 110eq par le système de diffusion 110, est effectuée dans la composante fréquentielle moyennée considérée dans une fenêtre temporelle donnée. Une information de détection est délivrée ;
- si l'information de détection est représentative d'une absence de détection du signal audiofréquence dans la composante fréquentielle moyennée, une valeur minimale dans la fenêtre temporelle donnée est retenue pour la composante fréquentielle considérée **(étape E210fb3b)** ; ou
- si l'information de détection est représentative d'une détection du signal audiofréquence dans la composante fréquentielle moyennée, la valeur minimale précédemment retenue pour la composante fréquentielle considérée est à nouveau retenue **(étape E210fb3a).**

Ainsi, lors d'une étape **E210spb,** un spectrogramme du signal de bruit représentatif du bruit de fond présent dans le véhicule 100 est estimé par concaténation des valeurs des composantes fréquentielles retenues lors de la mise en œuvre des étapes E210fb3b ou E210fb3a.

Lors d'une étape **E210tfi,** une transformées de Fourier inverse est appliquée au spectrogramme du signal de bruit, délivrant le signal de bruit ainsi estimé.

Dans d'autres modes de réalisation, d'autres méthodes d'estimation du signal de bruit sont mises en œuvre. Le signal de bruit est par exemple estimé en mettant en œuvre une méthode d'estimation spectrale de bruit de fond telle que mise en œuvre dans des méthodes de réduction de bruit par annulation d'échos, dites ECNR (pour « Echo Cancellation Noise Reduction » en anglais). De telles méthodes ECNR sont par exemple classiquement implémentées dans le domaine de la téléphonie mobile.

De retour à la [Fig.2a], lors d'une **étape E220,** un profil fréquentiel du signal de bruit est estimé. Par exemple, l'estimation du profil fréquentiel du signal de bruit comprend :
- une application d'un banc de filtres au signal de bruit délivrant une pluralité de signaux de bruit filtrés ;
- une détection d'enveloppe de chacun des signaux de bruit filtrés délivrant une pluralité correspondante d'enveloppes de signaux de bruit filtrés ; et
- un filtrage passe-bas de chacune des enveloppes de signaux de bruit filtrés délivrant une pluralité correspondante de composantes du profil fréquentiel du signal de bruit.

Dans certains modes de réalisation, l'estimation du profil fréquentiel du signal de bruit met en œuvre l'estimation d'un spectrogramme du signal de bruit, par exemple à partir de transformées de Fourier.

Dans certains modes de réalisation, l'estimation du profil fréquentiel du signal de bruit met en œuvre une correction de la (ou des) fonction de transfert du (ou des) microphones 120. Ainsi, les erreurs de capture du signal de bruit induites par les microphones sont compensées.

Le diagramme 300br de la [Fig.3a], illustre de telles composantes du profil fréquentiel du signal de bruit obtenues par mise en œuvre de l'étape E220.

De retour à la [Fig.2a], lors d'une **étape E230,** un profil fréquentiel souhaité pour le signal audiofréquences diffusé est déterminé. Plus particulièrement, un tel profil fréquentiel est représentatif du profil fréquentiel souhaité pour le signal audiofréquences au point d'écoute. La détermination du profil fréquentiel souhaité met en œuvre le calcul d'une répartition fréquentielle souhaitée pour l'énergie du signal audiofréquences, par exemple en fonction d'au moins un paramètre appartenant au groupe comprenant :
- un volume sonore de diffusion du signal audiofréquences, variable ou non en fonction d'une vitesse de déplacement dudit véhicule ;
- une intensité, variable en fréquence, dépendent du volume sonore (e.g. une égalisation fréquentielle dépendant du volume sonore) ;
- une égalisation fréquentielle prédéfinie, e.g. permettant d'atteindre une cible de balance tonale (ou cible fréquentielle) ;
- un ou plusieurs paramètres de configuration du système de diffusion 110 (e.g. des paramètres de tonalité, d'ambiance sonore, de répartition sonore, le paramétrage de certains effets, ou toute autre paramétrisation ayant une influence sur la réponse en intensité et en fréquence cible du système de diffusion 110) ; et
- lorsque le système de diffusion 110 comprend une pluralité de haut-parleurs 110hp, un ou plusieurs paramètres de répartition du signal audiofréquences entre les haut-parleurs 110hp. Le diagramme 300tg de la [Fig.3a], illustre de telles composantes du profil fréquentiel souhaité pour le signal audiofréquences diffusé obtenues par mise en œuvre de l'étape E230.

De retour à la [Fig.2a], lors d'une **étape E240** un masque acoustique fréquentiel représentatif, pour chaque composante fréquentielle, d'une différence entre, d'une part, une valeur du profil fréquentiel du signal de bruit obtenu lors de la mise en œuvre de l'étape E220 et, d'autre part, une valeur du profil fréquentiel souhaité obtenu lors de la mise en œuvre de l'étape E230. Dans une telle différence, les valeurs des profils fréquentiels sont exprimées en unité logarithmique ou en unité naturelles. Alternativement, le masque acoustique fréquentiel peut être obtenu, pour chaque composante fréquentielle, par division de la valeur de profil fréquentiel du signal de bruit par la valeur du profil fréquentiel souhaité lorsque les profils fréquentiels sont exprimés en unité naturelle. Dans ce cas cependant, le masque acoustique fréquentiel reste représentatif de la différence précitée.

Dans certains modes de réalisation, le masque acoustique fréquentiel est représentatif, pour chaque composante fréquentielle, de ladite différence lorsque la différence en question est supérieure à un seuil prédéterminé. En d'autres termes, le signal audiofréquences, pour une composante fréquentielle donnée, est considéré comme masqué si l'énergie du bruit de fond dépasse la valeur cible pour le signal audiofréquences d'une quantité au moins égale au seuil prédéterminé. Ainsi, le seuil peut être vu comme un décalage appliqué sur le masque acoustique.

Un tel seuil permet de prendre en compte et de préserver la dynamique du signal audiofréquences. Selon les implémentations, un tel seuil peut avoir une valeur par défaut et/ou également être adapté au fil du temps en fonction e.g. d'un paramétrage d'un utilisateur dans le véhicule, de la puissance du signal de bruit, etc.

Les diagrammes 310a et 310b de la [Fig.3b], illustrent de tels masques acoustiques fréquentiels obtenus par mise en œuvre de l'étape E240 pour deux valeurs différentes de seuil, i.e. pour une valeur de seuil de 4 dB et de 0 dB respectivement.

De retour à la [Fig.2a], lors d'une **étape E250** le signal audiofréquences est égalisé via une pondération de son spectre par application d'un masque de pondération fréquentiel fonction du masque acoustique fréquentiel. Un signal audiofréquences égalisé est ainsi obtenu.

Par exemple, un banc de filtres est appliqué au signal audiofréquences délivrant une pluralité correspondante de signaux audiofréquences filtrés. Chaque signal audiofréquences filtré est pondéré par une composante du masque de pondération fréquentiel correspondant à la bande de fréquence du signal audiofréquences filtré considéré.

Ainsi, la prise en compte du bruit effectif présent dans le véhicule via le ou les microphones permet une adaptation de l'égalisation à tous types de bruit pouvant être présents dans un tel véhicule (e.g. le bruit aérodynamique, le bruit moteur, du contact des pneus sur la route dans le cas d'un véhicule roulant, etc.) ainsi que leur évolution dans le temps.

Par ailleurs l'égalisation via une pondération du spectre du signal audiofréquences permet une égalisation plus fine que via l'utilisation d'un filtre classique du type filtre en plateau.

Dans certains modes de réalisation, le masque de pondération fréquentiel est obtenu par mise en œuvre d'une pondération de différentes composantes fréquentielles du masque acoustique fréquentiel par application de valeurs de pondérations prédéterminées.

Ainsi, la dureté ou la sibilance en haute fréquences peut être contrôlée. Ce contrôle par pondération permet également de prendre en compte perceptivement le manque de précision de l'extraction du bruit en le réglant à l'oreille en conditions opérationnelles pour un type de véhicules donné.

Selon les implémentations, de telles valeurs de pondérations peuvent avoir une valeur par défaut et/ou également être adaptées au fil du temps en fonction e.g. d'un paramétrage d'un utilisateur dans le véhicule, de la puissance du signal de bruit, etc.

Dans certains modes de réalisation, les valeurs du masque de pondération fréquentiel sont limitées à une valeur maximale et à une valeur minimale.

Par exemple, la valeur maximale définit une pondération maximale du spectre du signal audiofréquences permettant d'éviter toute divergence dans la détermination de la correction et limiter le gain global. Un gain excessif pourrait en effet trop modifier la perception audio (via l'effet « loudness » selon le terme anglosaxon consacré) cible du signal audiofréquences.

De même, la valeur minimale, e.g. correspondant à une pondération de 0 dB, permet de ne pas réduire (ou de limiter la réduction) de la dynamique du signal audiofréquences.

De retour à la [Fig.2a], lors d'une **étape E260** il est détecté si un (ou plusieurs) signal vocal est présent dans le signal de bruit. Une information de détection est ainsi délivrée. Par exemple, une telle information de détection peut être binaire, pouvant prendre deux valeurs représentatives des états logiques : détection d'un (ou plusieurs) signal vocal dans le bruit ou non-détection d'un (ou plusieurs) signal vocal dans le bruit.

En effet, dans certains modes de réalisation, les étapes précitées d'estimation (E210, E220), de détermination (E230, E240) et d'égalisation (E250) sont mises en œuvre périodiquement pour différents échantillons du signal capturé et du signal audiofréquences. Ainsi, l'égalisation fréquentielle implémente, pour une mise en œuvre donnée :
- lorsque l'information de détection est représentative d'une absence de détection d'un (ou plusieurs) signal vocal dans le signal de bruit : le masque de pondération fréquentiel correspondant au masque acoustique fréquentiel déterminé lors de la mise en œuvre donnée des étapes précitées ; ou
- lorsque l'information de détection est représentative d'une détection d'un (ou plusieurs) signal vocal dans le signal de bruit : le masque de pondération fréquentiel correspondant au masque acoustique fréquentiel déterminé lors d'une précédente mise en œuvre desdites étapes. Ainsi, les paramètres de correction sont gelés lorsque des signaux de voix non présents initialement dans le signal audiofréquences sont détectés dans le signal capturé issu du ou des microphones (e.g. la voix du ou des occupants du véhicule). De la sorte, des divergences ou des artéfacts dans l'égalisation sont évités.

Dans d'autres modes de réalisation l'information de détection délivrée lors de l'étape E260 est représentative d'un taux de probabilité de présence de signaux vocaux dans le signal de bruit. Dans ce cas, l'étape E260 comprend par exemple une estimation de la probabilité de présence d'un (ou plusieurs) signal vocal dans le signal de bruit (e.g. la voix d'un (ou plusieurs) occupant du véhicule). Pour ce faire, une méthode de détection de la voix, par exemple la technique VAD (pour « Voice Activity Detection » en anglais) du G.729, combinée avec la comparaison entre, d'une part, le signal audiofréquences envoyé aux haut-parleurs 110hp et, d'autre part, le signal capturé issu du (ou des) microphone 120 est par exemple mise en œuvre. En effet, la VAD permet de détecter la présence d'un (ou plusieurs) signal vocal dans le signal de bruit. La comparaison entre le signal audiofréquences et le signal capturé permet quant à elle de vérifier si le (ou les) signal vocal éventuellement détecté par la VAD est représentatif de la voix d'un (ou plusieurs) occupant présente dans le signal audiofréquences. Pour une telle comparaison, des techniques issues de l'ECNR peuvent être utilisées, par exemple :
- Comparaison du rapport des énergies desdits signaux audiofréquences et capturé à un seuil prédéterminé (méthode connue sous le nom de l'algorithme de Geigel) ; ou
- taux de corrélation entre lesdits signaux audiofréquences et capturé.

Une probabilité p de présence d'un (ou plusieurs) signal vocal dans le signal de bruit est ainsi calculée en fonction du taux de corrélation précité (e.g. p=f1(taux de corrélation)), ou du rapport des énergies précité (e.g. p=f2(rapport des énergies signaux)). Un exemple de fonction f1 est : f1(x)=x. Un exemple de la fonction f2 est : f2(x)=x si x<1 et f2(x)=1 si x≥1.

Dans de tels modes de réalisation de l'étape E260, le masque de pondération fréquentiel est pondéré en fonction de la probabilité de présence d'un (ou plusieurs) signal vocal dans le signal de bruit. Par exemple, la pondération α prend la forme : α(p)=1-p.

Dans de tels modes de réalisation, le masque de pondération fréquentiel Pvp(f) s'exprime par exemple comme Pvp(f)=PO(f)+ α(p).(Pm(f)-P0(f)), avec :
- PO(f) le masque acoustique fréquentiel déterminé lors d'une précédente mise en œuvre des étapes d'estimation (E210, E220), de détermination (E230, E240) et d'égalisation (E250).
- Pm(f) le masque acoustique fréquentiel déterminé lors de la mise en œuvre donnée des étapes précitées.

Ainsi, le masque de pondération fréquentiel Pvp(f) se réduit au masque acoustique fréquentiel PO(f) déterminé lors d'une précédente mise en œuvre des étapes précitées lorsque α(p)=0, i.e. lorsque la probabilité p de présence d'un signal vocal dans le signal de bruit est égale à 1. De même, le masque de pondération fréquentiel Pvp(f) se réduit au masque acoustique fréquentiel Pm(f) déterminé lors de la mise en œuvre donnée des étapes précitées lorsque α(p)=1, i.e. lorsque la probabilité p de présence d'un signal vocal dans le signal de bruit est nulle.

Dans certains modes de réalisation, d'autres expressions sont mises en œuvre pour la pondération α(p) et pour le masque de pondération fréquentiel Pvp(f). Cependant, dans de tels modes de réalisation, le masque de pondération fréquentiel Pvp(f) se réduit au masque acoustique fréquentiel PO(f) déterminé lors d'une précédente mise en œuvre des étapes précitées lorsque la probabilité p de présence d'un signal vocal dans le signal de bruit est égale à 1. De même, le masque de pondération fréquentiel Pvp(f) se réduit au masque acoustique fréquentiel Pm(f) déterminé lors de la mise en œuvre donnée des étapes précitées lorsque la probabilité p de présence d'un signal vocal dans le signal de bruit est nulle.

Dans certains modes de réalisation, un lissage (ou moyennage) temporel est appliqué au masque acoustique fréquentiel. Le lissage temporel suit la loi suivante : Pvp_m(n,f)=β(n).(Pvp(f)-Pvp_m(n-1,f)) avec :
- Pvp_m(n,f) le masque de pondération fréquentiel lissé dans le temps pour une fréquence f de la bande du signal à égaliser lors de la n-ième mise en œuvre des étapes d'estimation (E210, E220), de détermination (E230, E240) et d'égalisation (E250) ;
- Pvp(f) le masque de pondération fréquentiel tel que calculé ci-dessus ;
- Pvp_m(n-1,f) le masque de pondération fréquentiel lissé pour une fréquence f de la bande du signal à égaliser lors de la (n-1)-ième mise en œuvre desdites étapes ; et
- β(n) le facteur de pondération (appelé aussi facteur du suivi ou facteur d'oubli) dépendant de n selon un temps d'attaque (ou de décharge). Les valeurs de β(n) sont comprises entre 0 et 1 (i.e. 0<β(n)<1).

Dans certains modes de réalisation, la détection d'un (ou plusieurs) signal vocal dans le signal capturé est réalisé dans une bande étroite du signal capturé pour réduire les calculs nécessaires à cette détection. Un sous échantillonnage est réalisé pour adapter ledit signal à la bande étroite. Une telle bande étroite est par exemple limitée à 0...4kHz, qui comporte la partie la plus importante de l'énergie de la voix.

Cependant, dans certains modes de réalisation, l'étape E260 n'est pas mise en œuvre et les paramètres de correction utilisés pour l'égalisation lors de l'étape E250 ne sont pas gelés, mais mis à jour à chaque nouvelle mise en œuvre des étapes du procédé.

On présente désormais, en relation avec la **[****Fig.2c****]** les étapes du procédé d'égalisation du signal audiofréquences diffusé dans le véhicule 100 selon un autre mode de réalisation de l'invention. Le mode de réalisation de la [Fig.2c] diffère du mode de réalisation de la figure [Fig.2a] en ce que le profil fréquentiel du signal de bruit est estimé sans avoir besoin d'estimer préalablement le signal de bruit dans le domaine temporel.

Plus particulièrement, lors d'une **étape E220',** le profil fréquentiel du signal de bruit est estimé par mise en œuvre des étapes suivante :
- une application d'un banc de filtres au signal capturé délivrant une pluralité de signaux capturés filtrés ;
- pour chacun des signaux capturés filtrés : une mise en œuvre d'une méthode d'estimation spectrale de bruit de fond, à partir, d'une part, du signal capturé filtré et, d'autre part, du signal audiofréquences délivrant une pluralité correspondante de signaux de bruit filtrés ;
- une détection d'enveloppe de chacun des signaux de bruit filtrés délivrant une pluralité correspondante d'enveloppes de signaux de bruit filtrés ; et
- un filtrage passe-bas de chacune des enveloppes de signaux de bruit filtrés délivrant une pluralité correspondante de composantes du profil fréquentiel du signal de bruit.

Par exemple, la méthode d'estimation spectrale de bruit de fond en question est une méthode d'estimation spectrale de bruit de fond telle que mise en œuvre dans les méthodes ECNR précitées. Alternativement, les étapes décrites ci-dessus en relation avec l'étape E210 peuvent être mises en œuvre en lieu et place d'une méthode d'estimation spectrale de bruit de fond telle que mise en œuvre dans les méthodes ECNR afin d'estimer chaque signal de bruit filtré.

De retour à la [Fig.2c], par mise en œuvre des étapes E230, E240 et E250 telles que décrites ci-dessus en relation avec la [Fig.2a] et la [Fig.2b] (selon l'un quelconque des modes de réalisation précités) une égalisation du signal audiofréquences diffusé est obtenue sans avoir à estimer le signal de bruit en tant que tel.

Par ailleurs, selon le mode de réalisation de la [Fig.2c], le signal de bruit est estimé par sommation de chacun des signaux de bruit filtrés lors d'une **étape E210'.**

Ainsi, par mise en œuvre de l'étape E260 telles que décrites ci-dessus en relation avec la [Fig.2a] et la [Fig.2b] (selon l'un quelconque des modes de réalisation précités), il est détecté si un (ou plusieurs) signal vocal est présent dans le signal de bruit. De la sorte, les paramètres de correction utilisés pour l'égalisation lors de l'étape E250 sont gelés lorsque des signaux de voix non présents initialement dans le signal audiofréquences sont détectés dans le signal capturé issu du ou des microphones (e.g. la voix des passagers du véhicule). Ainsi, des divergences ou des artéfacts dans l'égalisation sont évités.

Cependant, dans certains modes de réalisation, les étapes E210' et E260 ne sont pas mises en œuvre et les paramètres de correction utilisés pour l'égalisation lors de l'étape E250 ne sont pas gelés, mais mis à jour à chaque nouvelle mise en œuvre des étapes du procédé.

On présente désormais, en relation avec la **[****Fig.4****]** un exemple de structure du dispositif 110eq permettant de mettre en œuvre des étapes du procédé d'égalisation (selon l'un quelconque des modes de réalisation décrit ci-dessus en relation avec la [Fig.2a], la [Fig.2b] ou la [Fig.2c]) selon un mode de réalisation de l'invention.

Le dispositif 110eq comprend une mémoire vive 403 (par exemple une mémoire RAM), une unité de traitement 402 équipée par exemple d'un (ou plusieurs) processeur(s), et pilotée par un programme d'ordinateur stocké dans une mémoire morte 401 (par exemple une mémoire ROM ou un disque dur). A l'initialisation, les instructions de code du programme d'ordinateur sont par exemple chargées dans la mémoire vive 403 avant d'être exécutées par le processeur de l'unité de traitement 402.

Cette Fig.4 illustre seulement une manière particulière, parmi plusieurs possibles, de réaliser le dispositif 110eq afin qu'il effectue certaines étapes du procédé d'égalisation (selon l'un quelconque des modes de réalisation et/ou variantes décrit(e)s ci-dessus en relation avec la [Fig.2a], la [Fig.2b] ou la [Fig.2c]). En effet, ces étapes peuvent être réalisées indifféremment sur une machine de calcul reprogrammable (un ordinateur PC, un (ou plusieurs) processeur(s) DSP ou un (ou plusieurs) microcontrôleur(s)) exécutant un programme comprenant une séquence d'instructions, ou sur une machine de calcul dédiée (par exemple un ensemble de portes logiques comme un (ou plusieurs) FPGA ou un (ou plusieurs) ASIC, ou tout autre module matériel).

Dans le cas où le dispositif 110eq est réalisé au moins en partie avec une machine de calcul reprogrammable, le programme correspondant (c'est-à-dire la séquence d'instructions) pourra être stocké dans un médium de stockage amovible (tel que par exemple un CD-ROM, un DVD-ROM, une clé USB) ou non, ce médium de stockage étant lisible partiellement ou totalement par un ordinateur ou un processeur.

Dans certains modes de réalisation, le système de diffusion 110 comprend le dispositif 110eq. Dans certains modes de réalisation, le dispositif 110eq est connecté au système de diffusion 110.

## Revendications

1. Procédé d'égalisation d'un signal audiofréquences diffusé dans un environnement de diffusion (100) par un système de diffusion (110) comprenant au moins un haut-parleur (110hp), le procédé étant **caractérisé en ce qu'**il comprend :
- une estimation (E220, E220') d'un profil fréquentiel d'un signal de bruit représentatif d'un bruit de fond présent dans l'environnement de diffusion, à partir, d'une part, d'un signal, dit signal capturé, issu d'une capture par au moins un microphone (120) implémenté dans l'environnement de diffusion et, d'autre part, dudit signal audiofréquences ;
- une détermination (E230) d'un profil fréquentiel souhaité pour ledit signal audiofréquences diffusé ;
- une détermination (E240) d'un masque acoustique fréquentiel représentatif, pour chaque composante fréquentielle, d'une différence entre ledit profil fréquentiel dudit signal de bruit et ledit profil fréquentiel souhaité ; et
- une égalisation (E250) dudit signal audiofréquences via une pondération d'un spectre dudit signal audiofréquences par application d'un masque de pondération fréquentiel fonction dudit masque acoustique fréquentiel, délivrant ledit signal audiofréquences égalisé.

2. Procédé selon la revendication 1 dans lequel ledit masque acoustique fréquentiel est représentatif, pour chaque composante fréquentielle, de ladite différence lorsque ladite différence est supérieure à un seuil prédéterminé.

3. Procédé selon la revendication 1 dans lequel ledit masque de pondération fréquentiel est obtenu par mise en œuvre d'une pondération de différentes composantes fréquentielles dudit masque acoustique fréquentiel par application de valeurs de pondérations prédéterminées.

4. Procédé selon la revendication 1 ou 2 dans lequel les valeurs dudit masque de pondération fréquentiel sont limitées à une valeur maximale et à une valeur minimale.

5. Procédé selon l'une quelconque des revendications 1 à 4 dans lequel ladite détermination d'un profil fréquentiel souhaité met en œuvre un calcul d'une répartition fréquentielle souhaitée d'une énergie dudit signal audiofréquences en fonction d'au moins un paramètre appartenant au groupe comprenant :
- un volume sonore de diffusion dudit signal audiofréquences ;
- une intensité, variable en fréquence, dépendent du volume sonore ;
- une égalisation fréquentielle prédéfinie ;
- un ou plusieurs paramètres de configuration dudit système de diffusion ; et
- lorsque ledit système de diffusion comprend une pluralité de haut-parleurs, un ou plusieurs paramètres de répartition dudit signal audiofréquences entre lesdits haut-parleurs.

6. Procédé selon l'une quelconque des revendications 1 à 5 dans lequel ladite estimation d'un profil fréquentiel dudit signal de bruit met en œuvre une correction d'une fonction de transfert dudit au moins un microphone.

7. Procédé selon l'une quelconque des revendications 1 à 6, comprenant :
- une estimation (E210, E210') dudit signal de bruit ; et
- une détection (E260) d'au moins un signal vocal présent dans ledit signal de bruit délivrant une information de détection, lesdites étapes d'estimation, de détermination et d'égalisation étant mises en œuvre périodiquement pour différents échantillons dudit signal capturé et dudit signal audiofréquences,
ladite égalisation fréquentielle implémentant, pour une mise en œuvre donnée :
- lorsque ladite information de détection est représentative d'une absence de détection d'au moins un signal vocal dans ledit signal de bruit : le masque de pondération fréquentiel correspondant au masque acoustique fréquentiel déterminé lors de la mise en œuvre donnée desdites étapes ; ou
- lorsque ladite information de détection est représentative d'une détection d'au moins un signal vocal dans ledit signal de bruit : le masque de pondération fréquentiel correspondant au masque acoustique fréquentiel déterminé lors d'une précédente mise en œuvre desdites étapes.

8. Procédé selon l'une quelconque des revendications 1 à 6, comprenant :
- une estimation (E210, E210') dudit signal de bruit ; et
- une détection (E260) d'au moins un signal vocal présent dans ledit signal de bruit délivrant une information de détection,
lesdites étapes d'estimation, de détermination et d'égalisation étant mises en œuvre périodiquement pour différents échantillons dudit signal capturé et dudit signal audiofréquences,
dans lequel ladite détection d'au moins un signal vocal met en œuvre une estimation d'une probabilité de présence d'au moins un signal vocal dans ledit signal de bruit,
ladite égalisation fréquentielle implémentant, pour une mise en œuvre donnée, le masque de pondération fréquentiel correspondant à une combinaison linéaire pondérée entre, d'une part, le masque acoustique fréquentiel déterminé lors d'une précédente mise en œuvre desdites étapes et, d'autre part, le masque acoustique fréquentiel déterminé lors de la mise en œuvre donnée desdites étapes, ladite pondération étant fonction de ladite probabilité de présence de sorte que ladite combinaison linéaire se réduit :
- au masque acoustique fréquentiel déterminé lors d'une précédente mise en œuvre desdites étapes lorsque la probabilité de présence d'au moins un signal vocal dans ledit signal de bruit est égale à 1 ; et
- au masque acoustique fréquentiel déterminé lors de la mise en œuvre donnée desdites étapes lorsque la probabilité de présence d'au moins un signal vocal dans ledit signal de bruit est nulle.

9. Procédé selon la revendication 8, dans lequel ladite combinaison linéaire pondérée s'exprime comme Pvp(f)=PO(f)+ α(p).(Pm(f)-P0(f)), avec :
- PO(f) le masque acoustique fréquentiel déterminé lors d'une précédente mise en œuvre des étapes d'estimation, de détermination et d'égalisation ;
- Pm(f) le masque acoustique fréquentiel déterminé lors de la mise en œuvre donnée des étapes précitées ; et
- α(p)=1-p ladite pondération fonction de ladite probabilité de présence, avec p ladite probabilité de présence.

10. Procédé selon la revendication 8 ou 9, dans lequel ladite égalisation fréquentielle implémente un lissage temporel du masque de pondération fréquentiel suivant la loi Pvp_m(n,f)=β(n).(Pvp(f)-Pvp_m(n-1,f)), avec :
- Pvp_m(n,f) le masque de pondération fréquentiel lissé dans le temps pour une fréquence f de la bande du signal à égaliser lors de la n-ième mise en œuvre des étapes d'estimation, de détermination et d'égalisation ;
- Pvp(f) le masque de pondération fréquentiel calculé lors de la n-ième mise en œuvre desdites étapes ;
- Pvp_m(n-1,f) le masque de pondération fréquentiel lissé pour une fréquence f de la bande du signal à égaliser lors de la (n-1)-ième mise en œuvre desdites étapes ; et
- β(n) un facteur de pondération compris entre 0 et 1.

11. Procédé selon l'une quelconque des revendications 7 à 10, dans lequel ladite estimation dudit signal de bruit met en œuvre une méthode d'estimation spectrale de bruit de fond, à partir, d'une part, dudit signal capturé et, d'autre part, dudit signal audiofréquences,
dans lequel ladite estimation dudit profil fréquentiel dudit signal de bruit comprend :
- une application d'un banc de filtres audit signal de bruit délivrant une pluralité de signaux de bruit filtrés,
- une détection d'enveloppe de chacun desdits signaux de bruit filtrés délivrant une pluralité correspondante d'enveloppes de signaux de bruit filtrés,
- un filtrage passe-bas de chacune desdites enveloppes de signaux de bruit filtrés délivrant une pluralité correspondante de composantes dudit profil fréquentiel dudit signal de bruit.

12. Procédé selon l'une quelconque des revendications 1 à 10, dans lequel ladite estimation dudit profil fréquentiel dudit signal de bruit comprend :
- une application d'un banc de filtres audit signal capturé délivrant une pluralité de signaux capturés filtrés,
- pour chacun desdits signaux capturés filtrés : une mise en œuvre d'une méthode d'estimation spectrale de bruit de fond, à partir, d'une part, dudit signal capturé filtré et, d'autre part, dudit signal audiofréquences délivrant une pluralité correspondante de signaux de bruit filtrés,
- une détection d'enveloppe de chacun desdits signaux de bruit filtrés délivrant une pluralité correspondante d'enveloppes de signaux de bruit filtrés,
- un filtrage passe-bas de chacune desdites enveloppes de signaux de bruit filtrés délivrant une pluralité correspondante de composantes dudit profil fréquentiel dudit signal de bruit, dans lequel ladite estimation dudit signal de bruit met en œuvre une sommation de chacun desdits signaux de bruit filtrés.

13. Procédé selon l'une quelconque des revendications 1 à 12 comprenant un moyennage d'une pluralité de signaux capturés chacun par un microphone différent implémenté dans l'environnement de diffusion, ledit moyennage délivrant ledit signal capturé.

14. Produit programme d'ordinateur comprenant des instructions de code de programme pour la mise en œuvre du procédé selon l'une quelconque des revendications 1 à 13, lorsque ledit programme est exécuté sur un ordinateur.

15. Dispositif d'égalisation (110eq) d'un signal audiofréquences diffusé dans un environnement de diffusion (100) par un système de diffusion (110) comprenant au moins un haut-parleur (110hp), le dispositif étant **caractérisé en ce qu'**il comprend une machine de calcul reprogrammable (402) ou une machine de calcul dédiée configurée pour effectuer :
- une estimation d'un profil fréquentiel d'un signal de bruit représentatif d'un bruit de fond présent dans l'environnement de diffusion, à partir, d'une part, d'un signal, dit signal capturé, issu d'une capture par au moins un microphone (120) implémenté dans l'environnement de diffusion et, d'autre part, dudit signal audiofréquences ;
- une détermination d'un profil fréquentiel souhaité pour ledit signal audiofréquences diffusé ;
- une détermination d'un masque acoustique fréquentiel représentatif, pour chaque composante fréquentielle, d'une différence entre ledit profil fréquentiel dudit signal de bruit et ledit profil fréquentiel souhaité lorsque lesdits profils fréquentiels sont exprimés en unité logarithmique ; et
- une égalisation dudit signal audiofréquences via une pondération d'un spectre dudit signal audiofréquences par application d'un masque de pondération fréquentiel fonction dudit masque acoustique fréquentiel, délivrant ledit signal audiofréquences égalisé.

## Patentansprüche

1. Verfahren zum Ausgleichen eines Audiofrequenzsignals, das in einer Sendeumgebung (100) durch ein Sendesystem (110), das mindestens einen Lautsprecher (110hp) umfasst, ausgesendet wird, wobei das Verfahren **dadurch gekennzeichnet ist, dass** es Folgendes umfasst:
- eine Schätzung (E220, E220') eines Frequenzprofils eines Rauschsignals, das repräsentativ für ein in der Sendeumgebung vorhandenes Hintergrundrauschen ist, ausgehend einerseits von einem Signal, das als erfasstes Signal bezeichnet wird und von einer Erfassung durch mindestens ein in der Sendeumgebung implementiertes Mikrofon (120) stammt, und andererseits von dem Audiofrequenzsignal;
- eine Bestimmung (E230) eines gewünschten Frequenzprofils für das ausgesendete Audiofrequenzsignal;
- eine Bestimmung (E240) einer akustischen Frequenzmaske, die für jede Frequenzkomponente repräsentativ für einen Unterschied zwischen dem Frequenzprofil des Rauschsignals und dem gewünschten Frequenzprofil ist; und
- einen Ausgleich (E250) des Audiofrequenzsignals durch eine Gewichtung eines Spektrums des Audiofrequenzsignals durch Anwendung einer Frequenzgewichtungsmaske in Abhängigkeit von der akustischen Frequenzmaske, wodurch das ausgeglichene Audiofrequenzsignal geliefert wird.

2. Verfahren nach Anspruch 1, wobei die akustische Frequenzmaske für jede Frequenzkomponente repräsentativ für den Unterschied ist, wenn der Unterschied größer als ein vorbestimmter Schwellenwert ist.

3. Verfahren nach Anspruch 1, wobei die Frequenzgewichtungsmaske durch die Durchführung einer Gewichtung verschiedener Frequenzkomponenten der akustischen Frequenzmaske durch Anwendung vorbestimmter Gewichtungswerte erhalten wird.

4. Verfahren nach Anspruch 1 oder 2, wobei die Werte der Frequenzgewichtungsmaske auf einen Maximalwert und einen Minimalwert begrenzt sind.

5. Verfahren nach einem der Ansprüche 1 bis 4, wobei die Bestimmung eines gewünschten Frequenzprofils eine Berechnung einer gewünschten Frequenzverteilung einer Energie des Audiofrequenzsignals in Abhängigkeit von mindestens einem Parameter aus der Gruppe umsetzt, die Folgendes umfasst:
- eine Sendelautstärke des Audiofrequenzsignals;
- eine frequenzvariable Intensität, die von der Lautstärke abhängt;
- einen vordefinierten Frequenzausgleich;
- einen oder mehrere Konfigurationsparameter des Sendesystems; und
- wenn das Sendesystem eine Vielzahl von Lautsprechern umfasst, einen oder mehrere Parameter zur Verteilung des Audiofrequenzsignals zwischen den Lautsprechern.

6. Verfahren nach einem der Ansprüche 1 bis 5, wobei die Schätzung eines Frequenzprofils des Rauschsignals eine Korrektur einer Übertragungsfunktion des mindestens einen Mikrofons umsetzt.

7. Verfahren nach einem der Ansprüche 1 bis 6, umfassend:
- eine Schätzung (E210, E210') des Rauschsignals; und
- eine Erkennung (E260) mindestens eines Sprachsignals, das in dem Rauschsignal vorhanden ist und eine Erkennungsinformation liefert,
wobei die Schritte der Schätzung, der Bestimmung und des Ausgleichs periodisch für verschiedene Proben des erfassten Signals und des Audiofrequenzsignals durchgeführt werden,
wobei der Frequenzausgleich für eine gegebene Durchführung Folgendes umsetzt:
- wenn die Erkennungsinformation für das Fehlen der Erkennung mindestens eines Sprachsignals in dem Rauschsignal repräsentativ ist: die Frequenzgewichtungsmaske, die der akustischen Frequenzmaske entspricht, die bei der gegebenen Durchführung der Schritte bestimmt wurde; oder
- wenn die Erkennungsinformation für eine Erkennung mindestens eines Sprachsignals in dem Rauschsignal repräsentativ ist: die Frequenzgewichtungsmaske, die der akustischen Frequenzmaske entspricht, die bei einer vorherigen Durchführung der Schritte bestimmt wurde.

8. Verfahren nach einem der Ansprüche 1 bis 6, umfassend:
- eine Schätzung (E210, E210') des Rauschsignals; und
- eine Erkennung (E260) mindestens eines Sprachsignals, das in dem Rauschsignal vorhanden ist und eine Erkennungsinformation liefert,
wobei die Schritte der Schätzung, der Bestimmung und des Ausgleichs periodisch für verschiedene Proben des erfassten Signals und des Audiofrequenzsignals durchgeführt werden,
wobei die Erkennung mindestens eines Sprachsignals eine Schätzung einer Wahrscheinlichkeit des Vorhandenseins mindestens eines Sprachsignals in dem Rauschsignal umsetzt, wobei der Frequenzausgleich für eine gegebene Durchführung die Frequenzgewichtungsmaske umsetzt, die einer gewichteten linearen Kombination zwischen einerseits der akustischen Frequenzmaske, die bei einer vorherigen Durchführung der Schritte bestimmt wurde, und andererseits von der akustischen Frequenzmaske, die bei der gegebenen Durchführung der Schritte bestimmt wurde, entspricht, wobei die Gewichtung von der Vorhandenseinswahrscheinlichkeit abhängt, so dass die lineare Kombination reduziert wird:
- auf die akustische Frequenzmaske, die bei einer vorherigen Durchführung der Schritte bestimmt wurde, wenn die Wahrscheinlichkeit des Vorhandenseins mindestens eines Sprachsignals in dem Rauschsignal 1 beträgt; und
- auf die akustische Frequenzmaske, die bei der gegebenen Durchführung der Schritte bestimmt wird, wenn die Wahrscheinlichkeit des Vorhandenseins mindestens eines Sprachsignals in dem Rauschsignal null beträgt.

9. Verfahren nach Anspruch 8, wobei die gewichtete lineare Kombination als Pvp(f)=PO(f)+ α(p).(Pm(f)-P0(f)) ausgedrückt wird, wobei:
- P0(f) die akustische Frequenzmaske ist, die bei einer vorherigen Durchführung der Schritte der Schätzung, der Bestimmung und des Ausgleichs bestimmt wurde;
- Pm(f) die akustische Frequenzmaske ist, die bei der gegebenen Durchführung der vorgenannten Schritte bestimmt wurde; und
- α(p)=1-p die Gewichtung in Abhängigkeit von der Vorhandenseinswahrscheinlichkeit ist, wobei p die Vorhandenseinswahrscheinlichkeit ist.

10. Verfahren nach Anspruch 8 oder 9, wobei der Frequenzausgleich eine zeitliche Glättung der Frequenzgewichtungsmaske nach dem Gesetz Pvp_m(n,f)=β(n).(Pvp(f)-Pvp_m(n-1,f)) umsetzt, wobei:
- Pvp_m(n,f) die zeitlich geglättete Frequenzgewichtungsmaske für eine Frequenz f des auszugleichenden Signalbandes bei der n-ten Durchführung der Schritte der Schätzung, der Bestimmung und des Ausgleichs ist;
- Pvp(f) die bei der n-ten Durchführung der Schritte berechnete Frequenzgewichtungsmaske ist;
- Pvp_m(n-1,f) die geglättete Frequenzgewichtungsmaske für eine Frequenz f des auszugleichenden Signalbands bei der (n-1)-ten Durchführung der Schritte ist; und
- β(n) ein Gewichtungsfaktor zwischen 0 und 1 ist.

11. Verfahren nach einem der Ansprüche 7 bis 10, wobei die Schätzung des Rauschsignals ein Verfahren zur spektralen Schätzung des Hintergrundrauschens umsetzt, ausgehend einerseits von dem erfassten Signal und andererseits von dem Audiofrequenzsignal, wobei die Schätzung des Frequenzprofils des Rauschsignals Folgendes umfasst:
- eine Anwendung einer Filterbank auf das Rauschsignal, die eine Vielzahl von gefilterten Rauschsignalen liefert,
- eine Hüllkurvenerkennung jedes der gefilterten Rauschsignale, die eine entsprechende Vielzahl von Hüllkurven der gefilterten Rauschsignale liefert,
- eine Tiefpassfilterung jeder der Hüllkurven der gefilterten Rauschsignale, die eine entsprechende Vielzahl von Komponenten des Frequenzprofils des Rauschsignals liefert.

12. Verfahren nach einem der Ansprüche 1 bis 10, wobei die Schätzung des Frequenzprofils des Rauschsignals Folgendes umfasst:
- eine Anwendung einer Filterbank auf das erfasste Signal, die eine Vielzahl von gefilterten erfassten Signalen liefert,
- für jedes der gefilterten erfassten Signale: eine Durchführung eines Verfahrens zur spektralen Schätzung des Hintergrundrauschens, ausgehend einerseits von dem gefilterten erfassten Signal und andererseits von dem Audiofrequenzsignal, das eine entsprechende Vielzahl von gefilterten Rauschsignalen liefert,
- eine Hüllkurvenerkennung jedes der gefilterten Rauschsignale, die eine entsprechende Vielzahl von Hüllkurven der gefilterten Rauschsignale liefert,
- eine Tiefpassfilterung jeder der Hüllkurven der gefilterten Rauschsignale, die eine entsprechende Vielzahl von Komponenten des Frequenzprofils des Rauschsignals liefert, wobei die Schätzung des Rauschsignals eine Summierung jedes der gefilterten Rauschsignale umsetzt.

13. Verfahren nach einem der Ansprüche 1 bis 12, das eine Mittelung einer Vielzahl von Signalen umfasst, die jeweils von einem anderen Mikrofon erfasst werden, das in der Sendeumgebung implementiert ist, wobei die Mittelung das erfasste Signal liefert.

14. Computerprogrammprodukt, das Programmcodeanweisungen für die Durchführung des Verfahrens nach einem der Ansprüche 1 bis 13 umfasst, wenn das Programm auf einem Computer ausgeführt wird.

15. Ausgleichsvorrichtung (110eq) für ein Audiofrequenzsignal, das in einer Sendeumgebung (100) durch ein Sendesystem (110), das mindestens einen Lautsprecher (110hp) umfasst, ausgesendet wird, wobei die Vorrichtung **dadurch gekennzeichnet ist, dass** sie eine wiederprogrammierbare Rechenmaschine (402) oder eine dedizierte Rechenmaschine umfasst, die konfiguriert ist, um Folgendes durchzuführen:
- eine Schätzung eines Frequenzprofils eines Rauschsignals, das für ein Hintergrundrauschen in der Sendeumgebung repräsentativ ist, ausgehend einerseits von einem Signal, das als erfasstes Signal bezeichnet wird und von einer Erfassung durch mindestens ein in der Sendeumgebung implementiertes Mikrofon (120) stammt, und andererseits von dem Audiofrequenzsignal;
- eine Bestimmung eines gewünschten Frequenzprofils für das ausgesendete Audiofrequenzsignal;
- eine Bestimmung einer akustischen Frequenzmaske, die für jede Frequenzkomponente repräsentativ für einen Unterschied zwischen dem Frequenzprofil des Rauschsignals und dem gewünschten Frequenzprofil ist, wenn die Frequenzprofile in logarithmischer Einheit ausgedrückt werden; und
- ein Ausgleich des Audiofrequenzsignals durch eine Gewichtung eines Spektrums des Audiofrequenzsignals durch Anwendung einer Frequenzgewichtungsmaske in Abhängigkeit von der akustischen Frequenzmaske, wodurch das ausgeglichene Audiofrequenzsignal geliefert wird.

## Claims

1. Method for equalizing an audio-frequency signal broadcast in a broadcasting environment (100) by a broadcasting system (110) comprising at least one loudspeaker (110hp), the method being **characterised in that** it comprises:
- estimating (E220, E220') a frequency profile of a noise signal representing a background noise present in the broadcasting environment, based on, on the one hand, a signal, called the captured signal, captured by at least one microphone (120) implemented in the broadcasting environment and, on the other hand, said audio-frequency signal;
- determining (E230) a desired frequency profile for said broadcast audio-frequency signal;
- determining (E240) an acoustic frequency mask representing, for each frequency component, a difference between said frequency profile of said noise signal and said desired frequency profile; and
- equalising (E250) the audio-frequency signal via a weighting of a spectrum of the audio-frequency signal by applying a frequency-weighting mask that is a function of the acoustic frequency mask, delivering the equalised audio-frequency signal.

2. Method according to claim 1, wherein the acoustic frequency mask represents, for each frequency component, said difference when said difference is greater than a predetermined threshold.

3. Method according to claim 1, wherein the frequency-weighting mask is obtained by weighting various frequency components of the acoustic frequency mask by applying predetermined weighting values.

4. Method according to claim 1 or 2, wherein the values of said frequency weighting mask are limited to a maximum value and to a minimum value.

5. Method according to any one of claims 1 to 4, wherein said determination of a desired frequency profile involves calculating a desired frequency division of an energy of the audio-frequency signal as a function of at least one parameter belonging to the group comprising:
- a sound volume for broadcasting said audio-frequency signal'
- an intensity, variable in frequency, depending on the sound volume;
- predefined frequency equalisation;
- one or more parameters for configuring said broadcasting system; and
- when said broadcasting system comprises a plurality of loudspeakers, one or more parameters for distributing said audio-frequency signal between said loudspeakers.

6. Method according to any one of claims 1 to 5, wherein said estimation of a frequency profile of said noise signal involves correcting a transfer function of said at least one microphone.

7. Method according to any one of claims 1 to 6, comprising:
- estimating (E210, E210') said noise signal; and
- detecting (E260) at least one voice signal present in said noise signal providing detection information,
said steps of estimating, determining and equalising are implemented periodically for various samples of said captured signal and of said audio-frequency signal,
said frequency equalisation implementing, for a given implementation:
- when said detection information represents an absence of detection of at least one voice signal in said noise signal: the frequency-weighting mask corresponding to the acoustic frequency mask determined during the given implementation of said steps; or
- when said detection information represents a detection of at least one voice signal in said noise signal: the frequency-weighting mask corresponding to the acoustic frequency mask determined during a previous implementation of said steps.

8. Method according to any one of claims 1 to 6, comprising:
- estimating (E210, E210') said noise signal; and
- detecting (E260) at least one voice signal present in said noise signal providing detection information,
said steps of estimating, determining and equalising are implemented periodically for various samples of said captured signal and of said audio-frequency signal,
wherein said detection of at least one voice signal involves estimating a probability of the presence of at least one voice signal in said noise signal,
said frequency equalisation implementing, for a given implementation, the frequency-weighting mask corresponding to a weighted linear combination between, on the one hand, , the frequency acoustic mask determined during a previous implementation of said steps and, on the other hand, the frequency acoustic mask determined during the given implementation of said steps, said weighting being a function of said probability of presence so that said linear combination is reduced:
- to the acoustic frequency mask determined during a previous implementation of said steps when the probability of the presence of at least one voice signal in said noise signal is equal to 1; and
- to the acoustic frequency mask determined during the given implementation of said steps when the probability of the presence of at least one voice signal in said noise signal is zero.

9. Method according to claim 8, wherein said weighted linear combination is expressed as Pvp(f)=PO(f)+ α(p).(Pm(f)-P0(f)), where:
- P0(f) is the acoustic frequency mask determined during a previous implementation of the steps of estimating, determining and equalising;
- Pm(f) is the acoustic frequency mask determined during the given implementation of the aforementioned steps; and
- α(p)=1-p is said weighting as a function of said probability of presence, with p said probability of presence.

10. Method according to claim 8 or 9, wherein said frequency equalisation implements temporal smoothing of the frequency-weighing mask according to the law Pvp_m(n,f)=β(n).(Pvp(f)-Pvp_m(n-1,f)), where:
- Pvp_m(n,f) is the frequency-weighting mask smoothed over time for a frequency f of the signal band to be equalised during the nth implementation of the steps of estimating, determining and equalising;
- Pvp(f) is the frequency-weighting mask calculated during the nth implementation of said steps;
- Pvp_m(n-1,f) is the smoothed frequency-weighting mask for a frequency f of the signal band to be equalised during the (n-1)th implementation of said steps; and
- β(n) is a weighting factor lying between 0 and 1.

11. Method according to any one of claims 7 to 10, wherein said estimation of said noise signal implements a method of spectral estimation of background noise, from, on the one hand, said captured signal and, on the other hand, said audio-frequency signal, wherein said estimation of said frequency profile of said noise signal comprises:
- applying a filter bank to said noise signal providing a plurality of filtered noise signals,
- detection of an envelope of each of said filtered noise signals providing a corresponding plurality of filtered noise signal envelopes,
- low-pass filtering of each of said filtered noise signal envelopes providing a corresponding plurality of components of the frequency profile of said noise signal.

12. Method according to any one of claims 1 to 10, wherein said estimation of said frequency profile of said noise signal comprises:
- applying a filter bank to said captured signal providing a plurality of filtered captured signals,
- for each of said filtered captured signals: implementing a method of spectral estimation of background noise, based on, on the one hand, said filtered captured signal and, on the other hand, said audio-frequency signal providing a corresponding plurality of filtered noise signals,
- detection of an envelope of each of said filtered noise signals providing a corresponding plurality of filtered noise signal envelopes,
- low-pass filtering of each of said filtered noise signal envelopes delivering a corresponding plurality of components of said frequency profile of said noise signal, wherein said estimation of said noise signal implements a summation of each of said filtered noise signals.

13. Method according to any one of claims 1 to 12 comprising averaging a plurality of signals each captured by a different microphone implemented in the broadcast environment, said averaging delivering said captured signal.

14. Computer program comprising program code instructions for implementing the method according to any one of claims 1 to 13 when said program is executed on a computer.

15. Device (110eq) for equalising an audio-frequency signal broadcast in a broadcast environment (100) by a broadcast system (110) comprising at least one speaker (110hp), the device being **characterised in that** it comprises a reprogrammable computing machine (402) or a dedicated computing machine configured to implement:
- an estimation of a frequency profile of a noise signal representing a background noise present in the broadcasting environment, based on, on the one hand, a signal, called the captured signal, captured by at least one microphone(120) implemented in the broadcasting environment and, on the other hand, said audio-frequency signal;
- a determination of a desired frequency profile for said broadcast audio-frequency signal;
- a determination of an acoustic frequency mask representing, for each frequency component, a difference between said frequency profile of said noise signal and said desired frequency profile when said frequency profiles are expressed in logarithmic units; and
- an equalisation of said audio-frequency signal via a weighting of a spectrum of said audio-frequency signal by applying a frequency-weighting mask that is a function of said acoustic frequency mask, delivering said equalised audio-frequency signal.
